(19) **Europäisches Patentamt**

**European Patent Office**

**Office européen des brevets**

(11) **EP 1 085 657 A1**

(12) **EUROPEAN PATENT APPLICATION**

(43) Date of publication:
21.03.2001 Bulletin 2001/12

(51) Int. Cl.7: **H03L 7/23**

(21) Application number: 00307720.3

(22) Date of filing: 06.09.2000

(84) Designated Contracting States:
**AT BE CH CY DE DK ES FI FR GB GR IE IT LI LU
MC NL PT SE**
Designated Extension States:
**AL LT LV MK RO SI**

(30) Priority: **17.09.1999 GB 9922068**

(71) Applicant:
**Sony United Kingdom Limited
Weybridge, Surrey KT13 0XW (GB)**

(72) Inventor: **Harpham, Simon
Southampton, SO14 3EE (GB)**

(74) Representative:
**Ayers, Martyn Lewis Stanley et al
J.A. KEMP & CO.
14 South Square
Gray's Inn
London WC1R 5LX (GB)**

(54) **Dual loop phase-locked loop**

(57) The present invention relates to a dual loop phase-locked loop (PLL) architecture suited to integration on a silicon monolithic integrated circuit. The dual loop phase-locked loop includes two PLLs 13a, 13b. The output signal from the first PLL 13a is fed to a mixer 24 arranged in the feedback loop of the second PLL after an initial frequency divider 20b. This reduces the power consumption of the device because the mixer 24 is operated at a lower frequency as a result of the frequency division in the initial frequency divider 20b. The second PLL 13b phase-locks the output of the mixer 24 to a comparison signal. The output signal from the first PLL 13a is fed to the mixer 24 through an intermediate frequency divider 24. The mixer may be implemented digitally as a D-type flip-flop.

Fig.3.

**EP 1 085 657 A1**

**Description**

The present invention relates to a dual loop phase-locked loop (PLL) which is suitable for synthesizing the local oscillator signal for a radio frequency transceiver such as a mobile telephone.

In a radio transceiver, it is common use a PLL to synthesize the variable local oscillator signal from a single reference source such as a crystal oscillator which has a stable output with low phase noise. The PLL generates an output signal phase-locked to the reference signal. Generally, the desired output radio frequency is higher than the reference frequency from a suitable reference source. When used as a local oscillator, an important property of a PLL is its channelisation, that is the gap between its output channels or its resolution.

The following types of PLL are known.

The oldest and most simple type is the single loop, integer-N PLL in which the output signal is fed back to the phase comparator of the PLL through a frequency divider having an integral division ratio N. Typically the comparison signal is derived by passing a reference signal through a reference frequency divider having an integral division ratio R. The output channelisation is equal to the comparison frequency. This type of PLL is well developed and has a sufficiently low power consumption to be suited to battery applications. However, this simple type of PLL suffers from phase noise problems when the division ratios R and N are set to provide a high output frequency with narrow channelisation.

The next most important type of PLL is the fractional-N PLL which has the same structure of the integer-N PLL except that the frequency division ratio of the feedback frequency divider is an integer plus a rational fraction. The channelisation of the output signal is therefore also a rational fraction of the comparison frequency. However, it is difficult to implement a fractional-N PLL for low noise and low power. A high performance fractional-N PLL requires a high complexity, consumes a large area of silicon and does not integrate easily with other low noise systems on the same die.

A third type of PLL is the multiplied DDS PLL where the reference frequency is synthesized by a variable clock rate ADC using a look-up table to generate a variable comparison frequency. The feedback division ratio is usually fixed at some low ratio to minimise the phase noise contribution from the phase comparator through the output spectrum. Channelisation is dependent on the clock rate and quantisation of the ADC and the granularity of the look-up table. A typical output resolution is a few Hz. However, this type of PLL has a high power consumption making it primarily suited to mains powered applications.

Improvements on a single loop PLL can be achieved by employing a dual loop PLL incorporating two phase-locked loops.

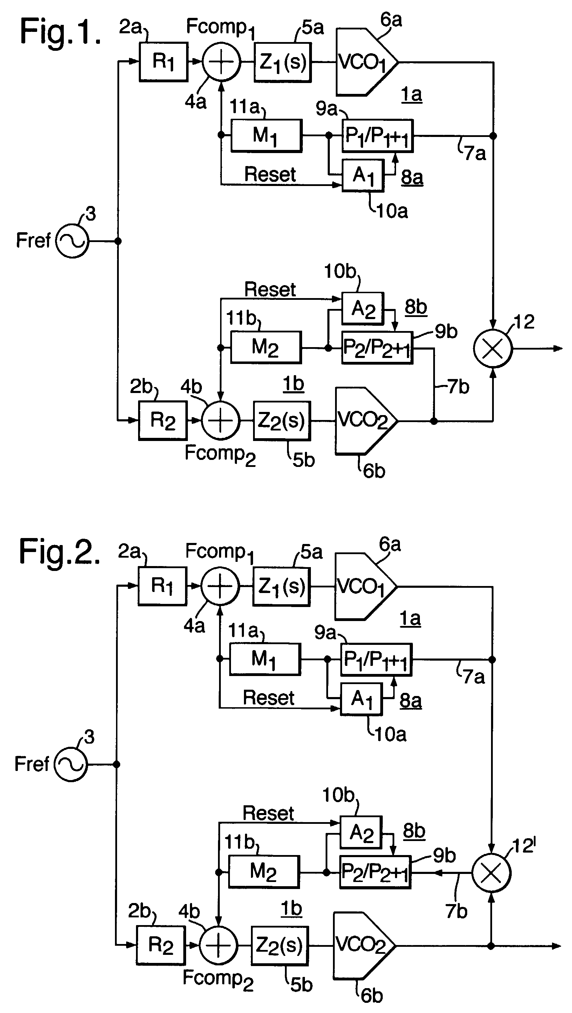

Two possible architectures of a dual loop PLL are illustrated in Figs. 1 and 2. Each architecture includes two PLLs 1a and 1b, containing identical elements the reference numerals of which are distinguished by the letters a and b. With either architecture, each PLL 1 consists of the following elements. A reference frequency divider 2 frequency divides the reference signal from a common reference source 3 to generate a comparison signal which is fed to a phase comparator 4 for comparison with a feedback signal. The output of the phase comparator 4 is representative of the phase difference between the comparison signal and the feedback signal and is fed as a control signal through a loop filter 5 for low-pass filtering to a voltage controlled oscillator (VCO) 6. The VCO 6 generates an output signal, the frequency of which is controlled by the input control signal. A feedback loop 7 is connected between the output of the VCO 6 and the phase comparator 4 to provide the feedback signal. Connected in the feedback loop is a frequency divider circuit consisting of a pre-scaler 7 and a frequency divider 11 having a frequency division ratio M. Pre-scaler 7 consists of a dual modulus pre-scaler 9 for counting P or (P + 1) cycles controlled by a swallow counter 10 arranged to count A output pulses so that the overall division ratio of the frequency divider is an integer $N= M.P+A$ . By giving each loop an integral division ratio, dual loop PLLs are suited to a low power, highly integrated applications.

In both architectures, the output signals of each loop 1 is fed to a mixer (numbered 12 in the first architecture and 12' in the second architecture) to mix the output signals. In the first dual PLL architecture illustrated in Fig. 1, the output of the mixer 12 is taken as the overall output of the dual loop PLL. Typically the mixer 12 generates the frequency sum of the output signals of the two PLLs 1a and 1b.

In the second dual PLL architecture illustrated in Fig. 2, the output of the mixer 12' is fed into the feedback loop of the second loop 1b. In this case, the mixer typically generates the frequency difference of the output signals of the two loops 1a and 1b so that the output signal of the VCO 6b of the second loop 1b is the same as the output frequency of the mixer 12 of the first implementation and is taken as the overall output signal.

The first architecture illustrated in Fig. 1 is of lower power, but the second architecture illustrated in Fig. 2 has a lower phase noise. Dual loop PLLs do not generally give as high an output resolution as the multiplied DDS PLL, but have a much lower power consumption and so are far more suitable to battery operated systems such as a mobile telephone.

The main shortcoming of the dual loop PLLs for portable applications is high power consumption which it would be desirable to reduce.

According to a first aspect of the present invention, there is provided a dual loop phase-locked loop comprising a first phase-locked loop arranged to output a first output signal phase-locked to a first comparison signal; and

a second phase-locked loop arranged to output a main output signal and having a feedback loop for feeding back the output signal, the feedback loop including at least an initial frequency divider, wherein a mixer receiving the first output signal at a first input is arranged in the feedback loop of the second phase-lock loop after the initial frequency divider so as to receive the main output signal fed back though the initial frequency divider at a second input and to output a mixed signal into the feedback loop.

The present invention provides a number of advantages. By arranging the mixer in the feedback loop of the second PLL, it is possible to reduce the power consumption of the dual loop PLL. As the main output signal is frequency divided by the initial frequency divider before being fed to the mixer. The mixer is driven at a lower frequency and hence consumes less current. Furthermore, it is possible to increase the power output of the main output signal from the second PLL without paying a penalty in power consumption at the mixer, because the main output signal is not fed directly to the mixer but is fed through the initial frequency divider. Thus, power consumption is reduced as compared to the possible dual loop PLL architectures illustrated in Figs. 1 and 2 in which at least one input of the mixer is operated at the main output frequency, and hence the mixer consumes a large amount of power. It may be noted that the present invention avoids the disadvantage with the first architecture illustrated in Fig. 1 that the power output through the mixer is restricted, making it unsuitable for some loop transmit architectures commonly used in modern mobile phone applications.

These advantages make the present invention suited to integration in a silicon monolithic integrated circuit (MIC).

Preferably the first and second comparison signals have the same frequency. Desirably the first and second comparison signals are synchronised. These measures reduce the generation of spurii in the output signal of the dual loop PLL.

Whilst it is possible to feed the output of the first feedback loop directly to the mixer, preferably the first output signal is fed from the first phase-locked loop to the mixer through an intermediate frequency divider.

This provides a number of advantages. It lowers the power consumption by the mixer. It enables a greater difference between the frequencies of the signals input to the mixer. This makes it easier to separate the frequency sum and difference signals in the output of the mixer. In contrast, this is difficult in the dual loop PLL architectures illustrated in Figs. 1 and 2.

In addition, the intermediate frequency divider is advantageous in that it brings down the frequency of this signal input to the mixer. As well as reducing power consumption, in some implementations this allows the mixer circuit is implemented digitally, for example as a D-type flip-flop. Such a digital implementation is much easier to design when integrating a dual loop PLL on a chip.

Preferably, the frequency division ratio of the intermediate frequency divider is an integer multiplied by the ratio of the frequency of the second comparison signal to the frequency of the first comparison signal. This enables the change in frequency of the main output signal with an integral change in the frequency division ratio of the signal output from the mixer to be an integral multiple of the change in the frequency of the main output signal with an integral change in the division ratio of a further frequency divider in the feedback loop of the second PLL. Thus, an integer frequency divider may be used in each loop to provide changes in the output frequency which are consistent between the loops. Accordingly, the resolution stays constant across the output frequency band with an integral change in the feedback division ratio of the first PLL.

Desirably the frequency division ratio of the intermediate frequency divider is set to be equal to the frequency division ratio of the initial frequency divider multiplied by the ratio of the first comparison frequency to the desired channel separation. Thus the frequency division ratio of the intermediate frequency divider control the desired channel separation allowing the first PLL to provide a finer control of the frequency of the main output signal than is achievable by the second phase-locked loop.

To allow better understanding, embodiments of the present invention will be described by way of non-limitative example, with reference to the accompanying drawings, in which:

Fig. 1 shows a first possible dual loop PLL architecture;
Fig. 2 shows a second possible dual loop PLL architecture;
Fig. 3 shows a dual loop PLL embodying the present invention; and
Fig. 4 illustrates a mobile telephone employing the dual loop PLL of Fig. 3.

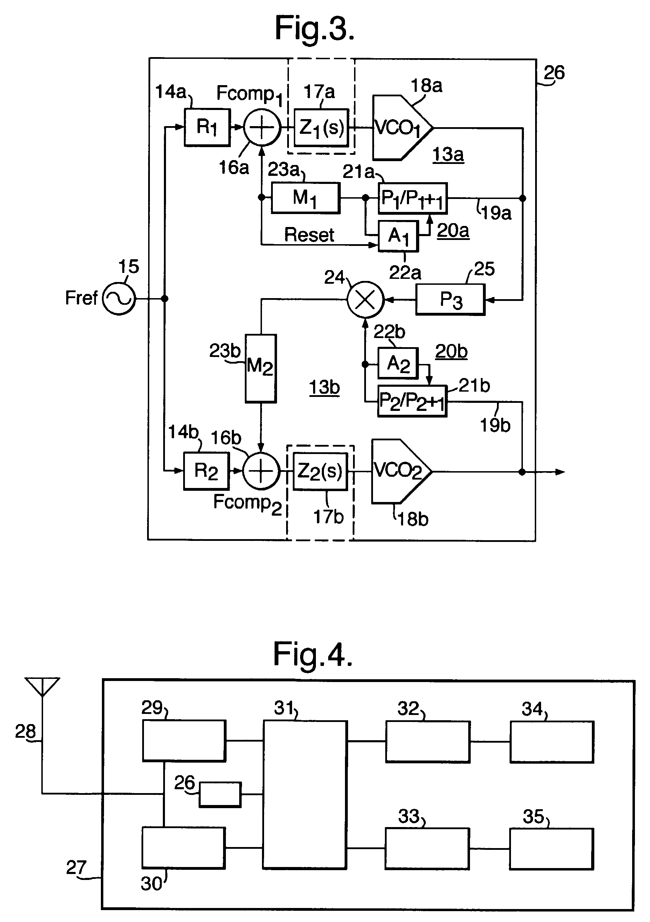

Fig. 3 illustrates the architecture of a dual loop PLL embodying the present invention. The dual loop PLL comprises two PLLs 13a and 13b which each have elements having a similar function and so will initially be described in common. The reference numerals of the elements of the two PLLs 13a and 13b are distinguished by the letters a and b.

Each PLL 13 is arranged as follows. A reference frequency divider 14 is fed with a reference signal from a reference source 15 which is common to both the first and second PLLs 13a and 13b. The reference frequency divider 14 divides the frequency of the reference signal by an integer R and outputs the frequency divided signal as a comparison signal to a phase comparator 16.

The phase comparator 16 compares the phase of the comparison signal with the phase of a feedback signal and outputs a control signal representative of the phase difference between the compared input. The control signal is passed through a loop filter 17. The phase comparator 16 output is provided by a positive and a negative current source which are respectively switched on for a positive or negative phase difference, for a duration equal to the phase difference. The loop filter 17 includes an integrator, such as a capacitor arranged in parallel with the control signal, for converting the output control signal current to a voltage level. The loop filter 17 further includes a filter arrangement for low-pass filtering the control signal.

The filtered control signal output from the loop filter 17 is supplied to a VCO 18 arranged to generate an output signal with a frequency which is controlled by the input control signal.

The output signal from the VCO 18 is fed back through a feedback loop 19 to the phase comparator 16, the output of the feedback loop 19 constituting the feedback signal which is compared with the comparison signal in the phase comparator 16. In the feedback loop 19, there are successively connected a pre-scaler 20, comprising a dual modulus pre-scaler 21 controlled by a swallow counter 22, and a frequency divider 23. The dual modulus pre-scaler 21 frequency divides the output signal of the PLL 13 by an integral ratio of either P or (P+1). The swallow counter 22 counts the output pulses from the dual modulus pre-scaler 21 and controls the frequency division ratio of the dual modulus pre-scaler 21 to be one of P and (P + 1) for A counts in a given set of counts and to be the other of P and (P + 1) for the remaining counts in the set of counts. The frequency divider 23 frequency divides the input signal by an integral division ratio N.

The elements of the two PLLs 13a and 13b which operate differently are as follows.

In the first PLL 13a, the reset of the swallow counter 22a is connected to the output of the frequency divider 23a. As a result the swallow counter 22a is arranged to control the division ratio of the dual modulus pre-scaler 21a to be $(P_1+1)$ for $A_1$ counts of the output counts of the dual modulus pre-scaler 21a in a set of $M_1$ counts, where $M_1$ is the frequency division ratio of the frequency divider 23a, and to be $P_1$ for the remaining counts in the set. Accordingly, the frequency divider circuit in the feedback loop 19a of the first PLL constituted by the pre-scaler 20a and frequency divider 23a has an integral division ratio $N_1$ given by the equation

$$N_1 = M_1 \cdot P_1 + A_1 \tag{1}$$

In the second PLL 13b, the swallow counter 22b has its reset removed such that it controls the division ratio of the dual modulus pre-scaler 21 to be $P_2$ for $A_2$ counts of the output pulses of the dual modulus pre-scaler 21 out of a maximum possible set of $P_2$ counts and to be $(P_2 + 1)$ for the remaining counts. Accordingly, the average division ratio $P_2'$ of the pre-scaler 20b is given by the equation

$$P_2' = (P_2 + 1) - (A/P_2) \tag{2}$$

A mixer 24 is disposed within the feedback loop 19b of the second PLL 13b after the pre-scaler 20b to receive the output of the pre-scaler 20b at one input, whereby the pre-scaler 20b constitutes an initial frequency divider in the feedback loop 19b. The output signal of the first PLL 13a is fed to the other input of the mixer 24 through an intermediate pre-scaler 25 which frequency divides the first output signal by an integral frequency division ratio $P_3$. The mixer 24 mixes the two input signals and feeds the output back into the feedback loop 19b, in particular to the frequency divider 23b.

The operation of the dual loop PLL is as follows.

The comparison signals of the first and second PLLs 13a and 13b are synchronised by deriving them from a common reference source 15. The first PLL 13a alone is effectively a standard single loop integral-N PLL. It produces a first output signal phase-locked to the first comparison signal output from the reference frequency divider 14. The first output signal has a frequency $F_1$ is related to the reference frequency $F_{ref}$ of the reference source 15 by the equation

$$F_1 = F_{ref} \cdot N_1/R_1 \tag{3}$$

The frequency $F_1'$ of the signal output from the intermediate frequency divider 25 is given by the equation

$$F'_1 = F_1/P_3 \tag{4}$$

The second PLL 13b phase-locks the output signal from the mixer 24 to the second comparison signal derived from the reference source 15 by the reference frequency divider 14b. Although not essential, desirably the comparison frequencies of the two PLLs 13a and 13b are made equal by setting the frequency division ratio of the reference frequency dividers 14a and 14b to the same value. This reduces the generation of spurii in the main output signal.

In the second PLL 13b the control of the VCO 18b drives the output frequency $F_2'$ of the mixer 24 to a value given by the equation

$$F_2' = F_{ref} \cdot M_2/R_2 \tag{5}$$

The output frequency of the second PLL 13b constitutes the main output signal of the dual loop PLL and is also fed back through the feedback loop 19b of the second PLL 13b. The input frequency $F_0'$ input to the mixer 24 through the pre-scaler 20b in the feedback loop 19b is related to the frequency $F_0$ of the main output signal by the equation

$$F_0' = F_0/P_2' \tag{6}$$

The mixer 24 can be arranged to perform frequency addition or subtraction, but subtraction is preferred so that the main output frequency is given by the following equation derived from equations (3) to (6),

$$F_0 = F_{ref}((N_1/R_1P_3) + (M_2/R_2)) \cdot P_2' \tag{7}$$

In general, the division ratios of the various pre-scalers and frequency dividers are selected to give a main output frequency and channelisation appropriate to a given implementation. However, it will be seen from equation (7) that an integral change in the feedback division ratio $M_2$ of frequency divider 23b within the second PLL 13b produces a change in the output frequency $dF_0$ of the main output signal of

$$dF_0 = (F_{ref}/ R_2) \cdot P_2' \tag{8}$$

Similarly, an integral change in the frequency division ration $N_1$ of the overall frequency divider circuit in the feedback loop 19a of the first PLL 13a produces a change in the output frequency $dF_0$ of the main output signal of

$$dF_0 = (F_{ref}/ R_1) \cdot (P_2' / P_3) \tag{9}$$

As the frequency division ratios $R_1$ and $R_2$ are preferably equal or at least similar, it is clear from equations (8) and (9) that an integral change of the frequency division ratio of the feedback frequency divider circuit in the feedback loop 19a of the first PLL 13a produces a smaller change in the output frequency if $P_3$ is large. Therefore, the first PLL 13a can be used to equation (9), the frequency division ratio $P_3$ of the intermediate frequency divider 25 can be set based on the desired channel separation $F_{sep}$ according to the equation

$$P_3 = (P_2' \cdot F_{ref}) / (R_1 \cdot F_{sep}) \tag{10}$$

Preferably, the ratio between the changes in output frequency produced by integral changes in $M_2$ or $N_1$ is also integral to provide consistency in the channel separation over a wide output frequency band. To achieve this it is clear from equation (8) and (9) that the frequency division ratio of the intermediate frequency divider is an integer multiplied by the ratio of the frequency of the second comparison signal to the frequency of the first comparison signal.

In order to minimise the input frequency $F_0'$ to the mixer it is desirable to set $P_2'$ and therefore $P_2$ as high as possible. However; this must be balanced against the need to minimise the overall division ratio in the feedback loop 19b of the second PLL 13b (given by $M_2 P_2'$ in equation (7)) in order to maximise the comparison frequency in the second PLL 13b at a given output frequency, because the settle time is inversely proportional to the comparison frequency and the phase noise reduces as the comparison frequency increases.

The following illustrates a typical numeral example for setting the various frequency division ratios in the PLL

| $F_{ref}$ 13MHz | | | | | | | |
|---|---|---|---|---|---|---|---|
| $P_1$ 32 | | $P_3$ | 1300 | | $P_2$ 1/4 | 16 | $\Rightarrow P_2' = 16$ |
| $R_1$ 13 | | | | | $R_2$ | 13 | |
| $F_{comp1}$ = 1000 kHz ($F_{ref}/R_1$) | | | | $F_{comp2}$ = 1000 kHZ ($F_{ref}/R_2$) | | | |
| $A_1$ | $M_1$ | $F_1$ MHz | $dF_1$ MHz | $A_1$ | $M_1$ | $F_0$ MHz | $dF_1$ MHz |
| 30 | 64 | 2078 | | 12 | 151 | 2479.7250 | |
| 31 | 64 | 2079 | 1 | 12 | 151 | 2479.7375 | 12.5 |
| 0 | 65 | 2080 | 1 | 12 | 151 | 2479.7500 | 12.5 |
| 13 | 24 | 781 | -1299 | 12 | 152 | 2479.7625 | 12.5 |
| 14 | 24 | 782 | 1 | 12 | 152 | 2479.7750 | 12.5 |

In this example, the comparison frequency is 80 times the resolution. The large step in frequency of the output signal of the first PLL indicates that the VCO 18a in the first PLL 13a should be a wide-band VCO capable of at least 1.5 octaves of tuning range. Fortunately, the phase noise requirements of this oscillator are quite relaxed, so this VCO 18a may be implemented digitally, for example as a ring of three invertors, this being possible on modern high speed BiCMOS processors.

As the main output signal from the second PLL 13b is fed back to the mixer 24 through the pre-scaler 20b, the mixer consumes less power than it would if operating at the output frequency. An associated advantage is that the VCO 18b of the second PLL 13b may produce power outputs sufficiently high for use in a radio transceiver circuit. This avoids the need for a separate power amplifier circuit which would typically require a further silicon MIC.

Providing a high frequency division ratio $P_3$ for the intermediate frequency divider 25 allows the mixer 24 to be implemented digitally, for example as a D-type flip-flop of which the clock input and the D input constitute its two inputs. Such a D-type flip-flop performs frequency subtraction of the two input signals.

If the mixer 24 has an analog implementation it may be arranged to perform frequency subtraction or addition by low or high pass filtering its output. Extracting the lower frequency band may be the effect of the frequency divider 23a receiving the output of the mixer 24.

The dual loop PLL is arranged in single silicon MIC the boundary of which is indicated by reference numeral 26. In some implementations, the filters 17a and 17b may be arranged off the MIC 26 in which case the boundary becomes the dotted outline.

A mobile telephone 27 implementing the MIC 26 of Fig. 3 is illustrated in Fig. 4. The main output from MIC 26 implementing the dual loop PLL is fed to a mixer 31 where it is used as a local oscillator signal to frequency convert a reception signal received from an antenna 28 through a reception circuit 29. The converted reception signal is supplied to a demodulator circuit 32 to generate an audio signal which is supplied to speaker 34. Similarly, an audio signal received by a microphone 35 is modulated by modulator 33 and supplied to the mixer 31 which frequency converts it using the output of the MIC 26. This creates a transmission signal which is supplied to a transmitter circuit 30 for transmission by the antenna 28.

**Claims**

1. A dual loop phase-locked loop comprising:

a first phase-locked loop (13a) arranged to output a first output signal phase-locked to a first comparison signal; and
a second phase-locked loop (13b) arranged to output a main output signal and having a feedback loop (19b) for feeding back the output signal, the feedback loop (19b) including at least an initial frequency divider (20b), wherein a mixer (24) receiving the first output signal at a first input is arranged in the feedback loop (19b) of the second phase-lock loop (13b) after the initial frequency divider (20b) so as to receive the main output signal fed back though the initial frequency divider (20b) at a second input and to output a mixed signal into the feedback loop (19b).

2. A dual loop phase-locked loop according to claim 1, wherein the first output signal is fed from the first phase-locked loop (13a) to the mixer through an intermediate frequency divider (25).

3. A dual loop phase-locked loop according to claim 2 , wherein the frequency division ratio of the intermediate frequency divider (25) is an integer multiplied by the ratio of the frequency of the second comparison signal to the frequency of the first comparison signal.

4. A dual loop phase-locked loop according to claim 2 or 3, wherein the frequency division ratio of the intermediate frequency divider (25) is set to be equal to the frequency division ratio of the initial frequency divider (20b) multiplied by the ratio of the first comparison frequency to the desired channel separation.

5. A dual loop phase-locked loop according to any one of the preceding claims, wherein the mixer (24) is implemented digitally.

6. A dual loop phase-locked loop, according to any one of the preceding claims, wherein the mixer (24) is arranged to perform frequency subtration of the two signals input to the mixer (24).

7. A dual loop phase-locked loop according to claim 6, wherein the mixer circuit (24) is a D-type flip-flop having a clock input and a D input which constitute the two inputs of the mixer (24), whereby the mixer performs a frequency subtraction of the two input signals.

8. A dual loop phase-locked loop according to any one of the preceding claims, wherein the initial frequency divider (206) comprises a fractional-N frequency divider constituted by a dual modulus pre-scaler (21b) controlled by a swallow counter (22b) connected to the output of the dual modulus counter (21b).

9. A dual loop phase-locked loop according to any one of the preceding claims, wherein the second phase-locked loop (13b) has a further frequency divider (23b) arranged in the feedback loop (19b) after the mixer (24).

10. A dual loop phase-locked loop according to any one of the preceding claims, wherein the first and second comparison signals have the same frequency.

11. A dual loop phase-locked loop according to any one of the preceding claims, wherein the first phase-locked loop (13a) further comprises an input frequency divider (14a) for dividing the frequency of an input oscillatory signal to generate the first comparison signal.

12. A dual loop phase-locked loop according to any one of the preceding claims, wherein the second phase-locked loop (13b) further comprises an input frequency divider (14b) for dividing the frequency of an input oscillatory signal to generate the second comparison signal.

13. A dual loop phase-locked loop according to any one of the preceding claims, wherein the first and second comparison signals are synchronised.

14. A dual loop phase-locked loop according to claim 13, wherein the first and second comparison signals are both derived from an oscillatory signal output from the same reference oscillator (15).

15. A dual loop phase-locked loop according to any one of the preceding claims, wherein the first phase-locked loop (13a) comprises:

a phase comparator (16a) comparing the phase of the first comparison signal with the phase of the first output signal fed back through a feedback loop (19a) and outputting a control signal representative of the phase difference; and
an oscillator circuit (18a) responsive to the control signal output from the phase comparator to generate the first output signal with a frequency controlled by the control signal.

16. A dual loop phase-locked loop according to claim 15, wherein the feedback loop (19a) of the first phase-locked loop (13a) includes a frequency divider (20a) for frequency dividing the first output signal.

**17.** A dual loop phase-locked loop according to claim 15 or 16, wherein the oscillator circuit (18a) of the first phase-locked loop (13a) is a voltage-controlled oscillator.

**18.** A dual loop phase-locked loop according to any one of claims 14 to 17, wherein the first phase-locked loop (13a) further comprises a loop filter (17a) for low-pass filtering the control signal before supply to the oscillator circuit (18a).

**19.** A dual loop phase-locked loop according to any one of the preceding claims, wherein the second phase-locked loop (13b) comprises:

a phase comparator (16b) for comparing the phase of the comparison signal with the phase of the signal fed back through the feedback loop (19b) and outputting a control signal representative of the phase difference; and
an oscillator circuit (18b) responsive to the control signal output from the phase comparator (16b) to generate the main output signal with a frequency controlled by the control signal.

**20.** A dual loop phase-locked loop according to claim 19, wherein the oscillator circuit (18b) of the second phase-locked loop (13b) is a voltage-controlled oscillator.

**21.** A dual loop phase-locked loop according to claim 19 to 20, wherein the second phase-locked loop (13b) further comprises a loop filter (17b) for low-pass filtering the control signal before supply to the oscillator circuit (18b).

**22.** A dual loop phase-locked loop according to any one of claims 19 to 21, wherein the oscillator circuit (18b) of the second phase-locked loop (13b) generates the main output signal with a sufficiently high power for a radio frequency transceiver circuit.

**23.** A monolithic integrated circuit (26) in which is integrated a dual loop phase-locked loop according to any one of the preceding claims.

**24.** A mobile telephone (27) including a dual loop phase-locked loop according to any one of claims 1 to 22, wherein the main output signal of the dual phase-locked loop fed to a mixer circuit of the mobile telephone as a local oscillation signal.

**25.** Use of a dual loop phase-locked loop according to any one of claims 1 to 22 as a local oscillator.

# Fig.1.

# Fig.2.

# Fig.3.

# Fig.4.

European Patent
Office

**EUROPEAN SEARCH REPORT**

Application Number

EP 00 30 7720

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 3 956 703 A (NOORDANUS JOHANNES ET AL) 11 May 1976 (1976-05-11) * column 3, line 1 - column 7, line 36; figures 4,5 * | 1,6,9, 11-25 | H03L7/23 |
| Y | | 2-5,7,8 | |
| X | US 5 267 182 A (WILKE WILLIAM G) 30 November 1993 (1993-11-30) * column 1, line 37 - line 40 * * column 5, line 45 - column 7, line 51 * * column 9, line 52 - line 60; figure 4D * | 1,6,9-25 | |
| Y | | 2-5,7,8 | |
| X | EP 0 717 491 A (HUGHES AIRCRAFT CO) 19 June 1996 (1996-06-19) * column 4, line 57 - column 7, line 8; figure 2 * | 1,2,6, 11-25 | |
| Y | US 5 128 633 A (MARTIN FREDERICK L ET AL) 7 July 1992 (1992-07-07) * column 2, line 19 - line 55; figure 1 * | 2-4 | TECHNICAL FIELDS SEARCHED (Int.Cl.7) |
| Y | US 4 225 828 A (WATANABE MASAHIRO ET AL) 30 September 1980 (1980-09-30) * column 3, line 36 - column 4, line 2; figure 3 * | 5,7 | H03L |
| Y | US 5 572 168 A (KASTURIA SANJAY) 5 November 1996 (1996-11-05) * column 2, line 65 - column 6, line 4; figures 1,4-6 * | 8 | |

The present search report has been drawn up for all claims

| Place of search | Date of completion of the search | Examiner |
|---|---|---|
| THE HAGUE | 28 December 2000 | Balbinot, H |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 00 30 7720

This annex lists the patent family members relating to the patent documents cited in the above-mentioned European search report.
The members are as contained in the European Patent Office EDP file on
The European Patent Office is in no way liable for these particulars which are merely given for the purpose of information.

28-12-2000

| Patent document cited in search report | | Publication date | Patent family member(s) | | Publication date |
|---|---|---|---|---|---|
| US 3956703 | A | 11-05-1976 | NL | 7405404 A | 24-10-1975 |
| | | | AU | 497169 B | 07-12-1978 |
| | | | AU | 8033575 A | 28-10-1976 |
| | | | BE | 828231 A | 22-10-1975 |
| | | | CA | 1032620 A | 06-06-1978 |
| | | | CH | 585485 A | 28-02-1977 |
| | | | DE | 2515969 A | 23-10-1975 |
| | | | FR | 2268391 A | 14-11-1975 |
| | | | GB | 1502988 A | 08-03-1978 |
| | | | IT | 1037441 B | 10-11-1979 |
| | | | JP | 939062 C | 30-01-1979 |
| | | | JP | 50147261 A | 26-11-1975 |
| | | | JP | 53017851 B | 12-06-1978 |
| | | | SE | 398583 B | 27-12-1977 |
| | | | SE | 7504477 A | 23-10-1975 |
| US 5267182 | A | 30-11-1993 | NONE | | |
| EP 0717491 | A | 19-06-1996 | US | 6122326 A | 19-09-2000 |
| US 5128633 | A | 07-07-1992 | EP | 0593642 A | 27-04-1994 |
| | | | JP | 6509217 T | 13-10-1994 |
| | | | WO | 9301657 A | 21-01-1993 |
| US 4225828 | A | 30-09-1980 | JP | 53130911 A | 15-11-1978 |
| | | | CA | 1091310 A | 09-12-1980 |
| US 5572168 | A | 05-11-1996 | GB | 2304242 A | 12-03-1997 |
| | | | JP | 9199943 A | 31-07-1997 |

EPO FORM P0459

For more details about this annex : see Official Journal of the European Patent Office, No. 12/82